# EUROPÄISCHE PATENTSCHRIFT

(11) **EP 0 285 799 B1**
(45) Veröffentlichungstag und Bekanntmachung des Hinweises auf die Patenterteilung: **28.07.1993**
(21) Anmeldenummer: 88103018.3
(22) Anmeldetag: 29.02.1988
(51) Int. Cl.: G01R 1/073, G01R 31/28, G01R 31/02

(54) **Vorrichtung für die elektrische Funktionsprüfung von Verdrahtungsfeldern, insbesondere von Leiterplatten**
Device for the functional electric testing of wiring arrays, in particular of circuit boards
Dispositif de test électrique du fonctionnement de rangées de fils électriques, en particulier pour cartes de circuit

(30) Priorität: 31.03.1987 DE 3710594
(43) Veröffentlichungstag der Anmeldung: 12.10.1988
(73) Patentinhaber: SIEMENS AKTIENGESELLSCHAFT, 80333 München (DE)
(72) Erfinder: Doemens, Günter, Dr. Ing., D-8150 Holzkirchen (DE); Rose, Thomas, Dr. rer. nat., D-8000 München 70 (DE)

(56) Entgegenhaltungen:
- EP-A- 0 102 565
- EP-A- 0 108 405
- EP-A- 0 115 135
- EP-A- 0 162 148
- EP-A- 0 216 135
- EP-A- 0 218 058
- DE-A- 3 337 915
- GB-A- 2 085 673
- GB-A- 2 136 140
- JP-A-62 056 871
- JP-A-62 056 872

## Beschreibung

Vorrichtung für die elektrische Funktionsprüfung von Verdrahtungsfeldern, insbesondere von Leiterplatten

Die Erfindung betrifft eine Vorrichtung für die elektrische Funktionsprüfung von Verdrahtungsfeldern, insbesondere von Leiterplatten, mit einer auf die Verdrahtungsfelder aufsetzbaren Trägerplatte, in welcher eine Vielzahl von Kontaktelementen angeordnet ist, wobei jeweils mindestens zwei ausgewählte Meßstellen eines Verdrahtungsfeldes über die zugeordneten Kontaktelemente kontaktierbar sind.

In Prüfautomaten und Prüfadaptern für unbestückte und bestückte Leiterplatten sowie für Verdrahtungsfelder in Löt- oder Crimptechnik wird die Kontaktierung der ausgewählten Meßstellen in der Regel über federnde Prüfspitzen vorgenommen. Die entsprechend dem Rastermaß eines zu prüfenden Verdrahtungsfeldes angeordneten federnden Prüfspitzen werden mittels Federhülsen befestigt, die in eine Trägerplatte eingepreßt sind und in die man die Prüfspitzen einschiebt (Elektronik Produktion & Prüftechnik, November 1979, Seiten 472 und 473).

Bei der Verwendung von federnden Prüfspitzen als Kontaktelemente treten bei abnehmendem Rastermaß und größer werdenden Flächen der Leiterplatten zunehmend Schwierigkeiten auf. So ist eine Anordnung der federnden Prüfspitzen in Rastermaßen unter einem Millimeter bei einer sicheren Kontaktierung der Prüfstellen feinwerktechnisch kaum mehr beherrschbar. Mit der Anzahl der Meßstellen, die beispielsweise Hunderttausend betragen kann, steigt auch die Anzahl der erforderlichen Zuleitungen und Schaltelemente, wodurch ein erheblicher gerätetechnischer Aufwand und entsprechend hohe Kosten verursacht werden.

Aus der EP-A- 0 102 565 ist eine Vorrichtung für die elektrische Funktionsprüfung von Verdrahtungsfeldern bekannt, bei welcher die bisher übliche ohm'sche Kontaktierung der Meßstellen durch eine berührungslose ionische Kontaktierung über Gasentladungsstrecken ersetzt wird. Hierzu wird in eine auf die Verdrahtungsfelder aufsetzbare Trägerplatte eine Vielzahl von mit Elektroden versehenen Gasentladungskanälen eingebracht, wobei die im Raster der Verdrahtungsfelder angeordneten Gasentladungskanäle zu den Meßstellen hin offen sind. Sind nun zwei ausgewählte Meßstellen beispielsweise durch eine Leiterbahn elektrisch leitend miteinander verbunden, so bilden die zugeordneten Gasentladungskanäle zwei in Reihe geschaltete Gasentladungsstrecken, die durch Anlegen einer hinreichend hohen Spannung an die Elektroden gezündet werden können. Mit der Zündung der Gasentladungen erfolgt dann ein Stromtransport, der zu Prüfzwecken ausgewertet werden kann. Unterbleibt die Zündung der Gasentladungen oder fließt nach einer Zündung ein zu geringer Strom, so kann auf eine unterbrochene oder von vorneherein nicht existierende elektrisch leitende Verbindung zwischen den ausgewählten Meßstellen geschlossen werden. Wird der an die Elektroden angelegten Spannung eine Wechselspannung überlagert, so kann die daraus resultierende Stromänderung phasenempfindlich zur angelegten Wechselspannung gemessen und für die Bestimmung des Widerstandes einer zwischen den ausgewählten Meßstellen bestehenden Verbindung herangezogen werden. Die bekannte Vorrichtung ermöglicht also Leitfähigkeits- und Isolationsmessungen, wobei durch das Vermeiden von ohm'schen Kontakten eine sehr hohe Zuverlässigkeit erreicht wird. Durch das Prinzip der ionischen Kontaktierung der Meßstellen über in äußerst geringen Abmessungen realisierbare Gasentladungskanäle können dann insbesondere auch Verdrahtungsfelder mit kleinen Rastermaßen der Meßstellen bis herab zu 0,1 mm zuverlässig geprüft werden. Bei der hohen Anzahl der Meßstellen eines zu prüfenden Verdrahtungsfeldes treten jedoch nach wie vor Probleme auf, die durch die zahlreichen Zuleitungen und Schaltelemente für den Anschluß der Elektroden der Gasentladungskanäle zurückzuführen sind.

Aus der JP-A-6 256 871 (veröffentlicht am 12.03.87), die der nicht vorveröffentlichten EP-A-0 216 135 entspricht, ist eine weitere Vorrichtung für die elektrische Funktionsprüfung von Verdrahtungsfeldern bekannt, bei welcher die Kontaktierung der Meßstellen ebenfalls berührungslos über Gasentladungsstrecken vorgenommen wird. Um die Anzahl der Zuleitungen zu den Elektroden der Gasentladungskanäle drastisch zu reduzieren, ist jeder Gasentladungskanal durch eine seiner Elektrode zugeordnete Sammelleitung und durch die steuerbare Beaufschlagung mit einer Gasentladungen einleitenden Strahlung beaufschlagbar. Die Beaufschlagung mit der Strahlung , durch welche die Zündbedingungen für Gasentladungen geschaffen werden, kann durch Strahlablenkung oder mittels Masken gesteuert werden.

Aus der EP-A-0 108 405 ist eine Vorrichtung zum Prüfen von Leiterplatten bekannt, bei welcher die Kontaktierung der Meßstellen über federnde Prüfspitzen vorgenommen wird. Pro Leiterplattentyp wird eine als Zwischenmaske dienende Folie eingesetzt, die durch ein spezielles Lochmuster die Kontaktierung sämtlicher Meßstellen dieses Leiterplattentyps ermöglicht. Die Folie verhindert Kurzschlüsse und gewährleistet, daß die zu prüfende Leiterplatte durch Auftreffen nur der unbedingt notwendigen Zahl von Prüfspitzen mechanisch geschont wird.

Der Erfindung liegt die Aufgabe zugrunde, bei einer Vorrichtung der eingangs genannten Art die Auswahl der einzelnen Meßstellen weiter zu vereinfachen.

Diese Aufgabe wird erfindungsgemäß dadurch gelöst, daß jede Meßstelle durch eine zugeordnete Sammelleitung und durch eine die Kontaktierung nicht ausgewählter Meßstellen verhindernde Zwischenmaske auswählbar ist.

Der Erfindung liegt die Erkenntnis zugrunde, daß der Anschluß von mehreren Kontaktelementen auf besonders einfache Weise unter der Voraussetzung über gemeinsame Sammelleitungen vorgenommen werden kann, daß als zusätzliche Bedingungen eine Zwischenmaske erforderlich ist, welche nur die Kontaktierung ausgewählter Meßstellen zuläßt und die Kontaktierung nicht ausgewählter Meßstellen verhindert. Eine eindeutige Adressierung ausgewählter Meßstellen kann also dadurch erreicht werden, daß die zugeordneten Sammelleitungen angesteuert werden und daß die eingesetzte Zwischenmaske nur eine Kontaktierung der ausgewählten Meßstellen zuläßt.

Mit der erfindungsgemäßen Adressierung der ausgewählten Meßstellen kann die Anzahl der Zuleitungen erheblich reduziert werden, zumal den Sammelleitungen auch eine größere Anzahl von Kontaktelementen zugeordnet werden kann. Neben einer erheblichen Verringerung des Verdrahtungsaufwandes wird insbesondere die technische Machbarkeit von Vorrichtungen für die elektrische Funktionsprüfung von Leiterplatten mit großen Leiterplattenformaten und kleinen Rastermaßen wesentlich erleichtert und somit auch eine entscheidende Senkung der Herstellkosten bewirkt. Der zusätzliche Aufwand für einen leiterplattenspezifischen Satz von Zwischenmasken kann gegenüber den genannten Vorteilen als gering eingestuft werden, zumal Herstellung und Handhabung der Zwischenmasken keinerlei Probleme aufwerfen.

Eine besonders einfache Handhabung der Zwischenmasken bei der elektrischen Funktionsprüfung ergibt sich dann, wenn die jeweilige Zwischenmaske zwischen der Trägerplatte und dem zu prüfenden Verdrahtungsfeld angeordnet wird.

Gemäß einer weiteren bevorzugten Ausgestaltung der Erfindung ist vorgesehen, daß in die Zwischenmaske den jeweils ausgewählten Meßstellen zugeordnete Löcher eingebracht sind. Hierdurch ergibt sich eine besonders einfache Herstellung der Zwischenmasken.

Gemäß einer besonders bevorzugten Ausgestaltung der Erfindung sind die Meßstellen parallel ausgerichteten Sammelleitungen reihenweise zugeordnet. Eine derartige reihenweise Zusammenfassung der Kontaktelemente ist insbesondere auf eine regelmäßige Rasteranordnung der Meßstellen abgestimmt, wie sie beispielsweise bei Leiterplatten in der Regel vorhanden ist. Es ergibt sich dann eine übersichtliche und besonders einfache Verlegung der Sammelleitungen.

Weiterhin ist es besonders vorteilhaft, wenn die Sammelleitungen quer, vorzugsweise unter einem Winkel von 45°, zu den Hauptrichtungen der zu prüfenden Verdrahtungsfelder verlaufen. Durch diese Maßnahme wird dem Umstand Rechnung getragen, daß zwei ausgewählten Meßstellen nicht die gleiche Sammelleitung zugeordnet sein darf. Verlaufen die Sammelleitungen beispielsweise unter einem Winkel von 45° zu den Hauptrichtungen der Verdrahtung, so können durch eine Verdrehung der gesamten Trägerplatte um einen Winkel von 90° oder 270° relativ zur Verdrahtung sämtliche Meßstellen sicher erfaßt werden.

Die Kontaktelemente können durch federnde Prüfspitzen gebildet sein. Bei Anwendung dieser konventionellen Technik ist es dann besonders vorteilhaft, wenn die Sammelleitungen und die zugeordneten federnden Prüfspitzen einstückig ausgebildet sind. Derartige Sammelleitungen mit integrierten Prüfspitzen können dann auf besonders einfache Weise ätztechnisch oder durch andere parallele Formgebungsverfahren wie z.B. durch Stanzen hergestellt werden. Die Möglichkeit des Einfederns wird dann vorzugsweise dadurch realisiert, daß die Prüfspitzen U-, V-oder Ω-förmige Federbereiche aufweisen.

Gemäß einer besonders bevorzugten Ausgestaltung der Erfindung sind die Kontaktelemente durch mit Elektroden versehene Gasentladungskanäle gebildet. In diesem Fall werden dann die Vorteile der erfindungsgemäßen Adressierung mit den Vorteilen der ionischen Kontaktierung vereinigt. Insbesondere können dann auch Verdrahtungsfelder mit kleinen Rastermaßen der Meßstellen bis herab zu 0,1 mm zuverlässig geprüft werden.

Bei der Verwendung von mit Elektroden versehenen Gasentladungskanälen ist es dann besonders günstig, wenn die Elektroden durch die Gasentladungskanäle überquerende Abschnitte der Sammelleitungen gebildet sind. Auf die Anbringung separater Elektroden kann in diesem Fall also verzichtet werden.

Ausführungsbeispiele der Erfindung sind in der Zeichnung dargestellt und werden im folgenden näher beschrieben.

Es zeigen
- Fig. 1: das Grundprinzip der Adressierung mit Zwischenmaske und Sammelleitungen bei einer mit Gasentladungskanälen versehenen Vorrichtung für die elektrische Funktionsprüfung von Leiterplatten und
- Fig. 2: das Grundprinzip der Adressierung mit Zwischenmaske und Sammelleitungen bei einer mit federnden Prüfspitzen versehenen Vorrichtung für die elektrische Funktionsprüfung von Leiterplatten.

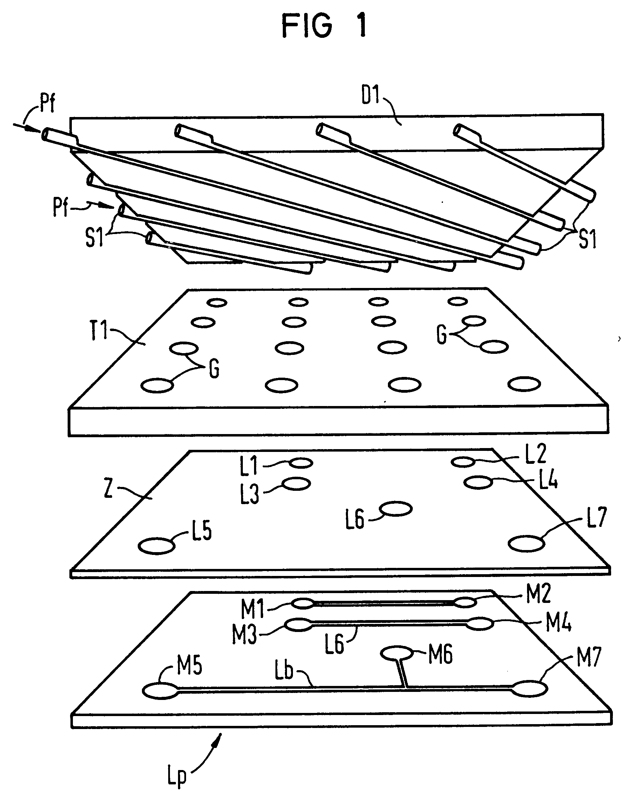

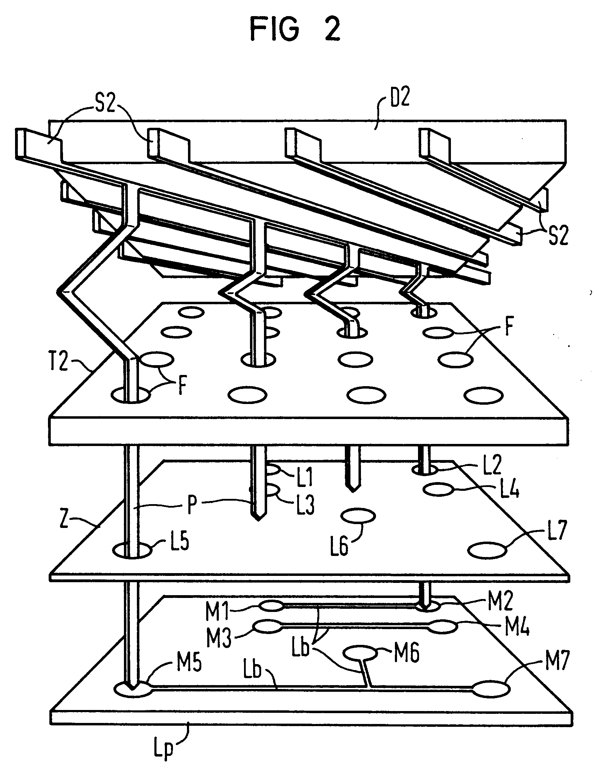

Mit den in den Figuren 1 und 2 dargstellten Vorrichtungen soll die elektrische Funktionsprüfung einer stark vereinfacht dargestellten Leiterplatte Lp vorgenommen werden, auf deren Oberfläche jeweils Anschlußflächen bzw. Meßstellen M1 und M2, M3 und M4 sowie M5 und M7 durch horizontal verlaufende Leiterbahnen Lb miteinander verbunden sind. Von der zwischen den Meßstellen M5 und M7 verlaufenden Leiterbahn Lb zweigt eine weitere vertikal verlaufende Leiterbahn Lb ab, die an einer Meßstelle M6 endet.

Bei den beiden in den Figuren 1 und 2 dargestellten Vorrichtungen erfolgt die erfindungsgemäße Adressierung der Meßstellen M1 bis M7 mit Hilfe einer Zwischenmaske Z, in welche den Meßstellen M1 bis M7 zugeordnete Löcher L1 bis L7 eingebracht sind. Wie nachfolgend näher erläutert wird, haben die mit wechselnden Lochkonfigurationen versehenen Zwischenmasken Z bei beiden Vorrichtungen die Aufgabe, die Kontaktierung nicht ausgewählter Meßstellen zu verhindern und nur die Kontaktierung ausgewählter Meßstellen zu ermöglichen.

Bei der in Figur 1 dargestellten Vorrichtung ist in der auseinandergezogenen Darstellung eine Trägerplatte T1 aus isolierendem Material zu erkennen, in die entsprechend dem Rastermaß der Leiterplatte Lp Gasentladungskanäle G eingebracht sind. Oberhalb dieser Trägerplatte T1 befindet sich eine ebenfalls aus isolierendem Material bestehende Deckplatte D1, in deren Unterseite mit S1 bezeichnete Sammelleitungen teilweise eingelassen bzw. eingesteckt sind. Diese parallel zueinander ausgerichteten Sammelleitungen S1 verlaufen unter einem Winkel von 45° zur horizontalen Richtung der Leiterbahnen Lb derart, daß sie jeweils diagonale Reihen der Gasentladungskanäle G überqueren. Die Elektroden der Gasentladungskanäle G werden dabei durch die Gasentladungskanäle G überquerende Abschnitte der Sammelleitungen S1 gebildet.

Soll nun beispielsweise die elektrisch leitende Verbindung zwischen den Meßstellen M1 und M2 überprüft werden, so wird im einfachsten Fall eine Zwischenmaske Z eingesetzt, in welche nur die Löcher L1 und L2 eingebracht sind. Diese Zwischenmaske Z, die Trägerplatte T1 und die Deckplatte D1 werden dann übereinander auf die Leiterplatte Lp aufgesetzt, worauf an die beiden durch Pfeile Pf gekennzeichnete Sammelleitungen S1 die doppelte Zündspannung einer Gasentladungsstrecke angelegt wird. Sind nun die beiden Meßstellen M1 und M2 durch die dazwischen verlaufende Leiterbahn Lb elektrisch leitend miteinander verbunden, so bilden die zugeordneten Gasentladungskanäle G zwei in Reihe geschaltete Gasentladungsstrecken, die durch das Anlegen der doppelten Zündspannung an die Elektroden bzw. Sammelleitungen S1 gezündet werden. Mit der Zündung der Gasentladungen erfolgt dann ein Stromtransport, der zu Prüfzwecken ausgewertet werden kann. Sind den beiden durch Pfeile gekennzeichnete Sammelleitungen S1 weitere elektrisch leitend miteinander verbundene Meßstellen zugeordnet, so wird deren Kontaktierung durch die Zwischenmaske Z sicher verhindert.

Sollten zwei ausgewählte Meßstellen der gleichen Sammelleitung S1 zugeordnet sein, so wird die aus Trägerplatte T1 und Deckplatte D1 bestehende Einheit um einen Winkel von 90° oder 270° verdreht und dann erst auf Zwischenmaske Z und Leiterplatte Lp aufgesetzt. In dieser verdrehten Lage sind dann den beiden ausgewählten Meßstellen zwei verschiedene Sammelleitungen S1 zugeordnet.

Bei der in Figur 2 dargestellten Vorrichtung ist in der auseinandergezogenen Darstellung eine Trägerplatte T2 zu erkennen, in die entsprechend dem Rastermaß der Leiterplatte Lp Führungskanäle F für mit P bezeichnete Prüfspitzen eingebracht sind. Oberhalb dieser Trägerplatte T2 befindet sich eine aus isolierendem Material bestehende Deckplatte D2, in deren Unterseite mit S2 bezeichnete Sammelleitungen eingelassen bzw. eingesteckt sind. Auch diese parallel zueinander ausgerichteten Sammelleitungen S2 verlaufen zur horizontalen Richtung der Leiterbahnen Lb unter einem Winkel von 45°, wobei im Bedarfsfall relativ zur Leiterplatte Lp um 90° oder 270° verdrehte Anordnungen möglich sind. Die Sammelleitungen S2 sind mit sämtlichen zugeordneten Prüfspitzen P einstückig verbunden, was zur Vereinfachung der zeichnerischen Darstellung nur für eine einzige Sammelleitung S2 aufgezeigt ist. Die aus einer Sammelleitung S2 und den zugeordneten Prüfspitzen P bestehenden Einheiten werden beispielsweise ätztechnisch aus einem Blech hergestellt. Die streifenförmigen Prüfspitzen P weisen in ihrem oberen Bereich V-förmige Ausknickungen V auf, die als Federbereiche dienen und somit ein elastisches Einfedern ermöglichen.

Das Prinzip der Adressierung ausgewählter Meßstellen mit der Zwischenmaske Z ist in Figur 2 bereits aus der einen diagonalen Reihe von Prüfspitzen P ersichtlich. Die Kontaktierung der Meßstellen M2 und M5 wird durch die Löcher L2 und L5 der Zwischenmaske Z ermöglicht, während sämtliche anderen Prüfspitzen P dieser Reihe von der Zwischenmaske Z zurückgehalten werden und beim Absenken der aus Trägerplatte T2 und Deckplatte D2 bestehenden Einheit auf die Leiterplatte L2 elastisch einfedern. Im übrigen wird die elektrische Funktionsprüfung ähnlich wie bei der in Figur 1 dargestellten Vorrichtung vorgenommen, wobei an die Stelle der ionischen Kontaktierung mit den Gasentladungskanälen G eine ohm'sche Kontaktierung mit den Prüfspitzen P tritt.

## Patentansprüche

1. Vorrichtung für die elektrische Funktionsprüfung von Verdrahtungsfeldern, insbesondere von Leiterplatten (Lp), mit einer auf die Verdrahtungsfelder aufsetzbaren Trägerplatte (T1;T2), in welcher eine Vielzahl von Kontaktelementen angeordnet ist, wobei jeweils mindestens zwei ausgewählte Meßstellen (M1 bis M7) eines Verdrahtungsfeldes über die zugeordneten Kontaktelemente kontaktierbar sind,
**dadurch gekennzeichnet,**
daß jede Meßstelle (M1 bis M7) durch eine zugeordnete Sammelleitung (S1;S2) und durch eine die Kontaktierung nicht ausgewählter Meßstellen (M1 bis M7) verhindernde Zwischenmaske (Z) auswählbar ist.

2. Vorrichtung nach Anspruch 1,
**dadurch gekennzeichnet,**
daß die Zwischenmaske (Z) zwischen der Trägerplatte (T1;T2) und dem zu prüfenden Verdrahtungsfeld angeordnet ist.

3. Vorrichtung nach Anspruch 1 oder 2,
**dadurch gekennzeichnet,**
daß in die Zwischenmaske (Z) den jeweils ausgewählten Meßstellen (M1 bis M7) zugeordnete Löcher (L1 bis L7) eingebracht sind.

4. Vorrichtung nach einem der vorhergehenden Ansprüche,
**dadurch gekennzeichnet,**
daß die Meßstellen (M1 bis M7) parallel ausgerichteten Sammelleitungen (S1;S2) reihenweise Zugeordnet sind.

5. Vorrichtung nach Anspruch 4,
**dadurch gekennzeichnet,**
daß die Sammelleitungen (S1;S2) quer zu den Hauptrichtungen der Verdrahtung der zu prüfenden Verdrahtungsfelder verlaufen.

6. Vorrichtung nach Anspruch 5,
**dadurch gekennzeichnet,**
daß die Sammelleitungen (S1;S2) unter einem Winkel von 45° zu den Hauptrichtungen der zu prüfenden Verdrahtungsfelder verlaufen.

7. Vorrichtung nach einem der vorhergehenden Ansprüche,
**dadurch gekennzeichnet,**
daß die Kontaktelemente durch federnde Prüfspitzen (P) gebildet sind.

8. Vorrichtung nach Anspruch 7,
**dadurch gekennzeichnet,**
daß die Sammelleitungen (S2) und die zugeordneten federnden Prüfspitzen (P) einstückig ausgebildet sind.

9. Vorrichtung nach Anspruch 8,
**dadurch gekennzeichnet,**
daß die Prüfspitzen (P) U-, V- oder Ω-förmige Federbereiche aufweisen.

10. Vorrichtung nach einem der Ansprüche 1 bis 6,
**dadurch gekennzeichnet,**
daß die Kontaktelemente durch mit Elektroden versehene Gasentladungskanäle (G) gebildet sind.

11. Vorrichtung nach Anspruch 10,
**dadurch gekennzeichnet,**
daß die Elektroden durch die Gasentladungskanäle (G) überquerende Abschnitte der Sammelleitungen (S1) gebildet sind.

## Claims

1. Device for the electrical functional testing of wiring panels, preferably of printed-circuit boards (Lp), having a carrier board (T1; T2) which can be placed onto the wiring panels and in which a multiplicity of contact elements are arranged, it being possible to make contact in each case with at least two selected measurement points (M1 to M7) of a wiring panel via the associated contact elements, characterised in that each measurement point (M1 to M7) can be selected by means of an associated bus line (S1; S2) and by means of an intermediate mask (Z) which prevents contact being made at non-selective measurement points (M1 to M7).

2. Device according to Claim 1, characterised in that the intermediate mask (Z) is arranged between the carrier board (T1; T2) and the wiring panel which is to be tested.

3. Device according to Claim 1 or 2, characterised in that holes (L1 to L7) which are allocated to the respectively selected measurement points (M1 to M7) are incorporated in the intermediate mask (Z).

4. Device according to one of the preceding claims, characterised in that the measurement points (M1 to M7) are allocated bus lines (S1; S2) which are aligned parallel, in rows.

5. Device according to Claim 4, characterised in that the bus lines (S1; S2) run transversely with respect to the main directions of the wiring of the wiring panels which are to be tested.

6. Device according to Claim 5, characterised in that the bus lines (S1; S2) run at an angle of 45° with respect to the main directions of the wiring panels which are to be tested.

7. Device according to one of the preceding claims, characterised in that the contact elements are formed by sprung test probes (P).

8. Device according to Claim 7, characterised in that the bus lines (S2) and the associated sprung test probes (P) are constructed integrally.

9. Device according to Claim 8, characterised in that the test probes (P) have U-shaped, V-shaped or Ω-shaped spring regions.

10. Device according to one of Claims 1 to 6, characterised in that the contact elements are formed by means of gas-discharge channels (G) which are provided with electrodes.

11. Device according to Claim 10, characterised in that the electrodes are formed by means of sections of the bus lines (S1) which cross over the gas-discharge channels (G).

## Revendications

1. Dispositif pour le contrôle électrique du fonctionnement de réseaux de câblage, notamment de circuits à imprimés (Lp), comportant une plaque de support (T1;T2) pouvant être apposée sur les réseaux de câblage et dans laquelle sont disposés une multiplicité d'éléments de contact, et dans lequel un contact peut être établi avec respectivement au moins deux points de mesure sélectionnés (M1 à M7) d'un réseau de câblage, et par l'intermédiaire des éléments de contact associés, caractérisé par le fait que chaque point de mesure (M1 à M7) peut être sélectionné par l'intermédiaire d'une ligne formant bus associée (ES1;ES2) et au moyen d'un masque intermédiaire (Z) empêchant l'établissement du contact avec des points de mesure (M1 à M7) non sélectionnés.

2. Dispositif suivant la revendication 1, caractérisé par le fait que le masque intermédiaire (Z) est disposé entre la plaque de support (T1;T2) et le réseau de câblage à contrôler.

3. Dispositif suivant la revendication 1 ou 2, caractérisé par le fait que des trous (L1 à L7), qui sont associés aux points respectifs de mesure (M1 à M7) sélectionnés, sont aménagés dans le masque intermédiaire (Z).

4. Dispositif suivant l'une des revendications précédentes, caractérisé par le fait que les points de mesure (M1 à M7) sont associés en série à des lignes formant bus parallèles (S1;S2).

5. Dispositif suivant la revendication 4, caractérisé par le fait que les barres des lignes formant bus (S1,S2) s'étendent transversalement par rapport aux directions principales des câblages des réseaux de câblage à contrôler.

6. Dispositif suivant la revendication 5, caractérisé par le fait que les lignes formant bus (S1;S2) font un angle de 45° par rapport aux directions principales des réseaux de câblage à contrôler.

7. Dispositif suivant l'une des revendications précédentes, caractérisé par le fait que les éléments de contact sont formés par des pointes élastiques de contrôle (P).

8. Dispositif suivant la revendication 7, caractérisé par le fait que les lignes formant bus (S2) et les pointes élastiques de contrôle associées sont réalisées d'un seul tenant.

9. Dispositif suivant la revendication 8, caractérisé par le fait que les pointes de contrôle (P) possèdent des parties formant ressorts en forme de U, V ou Ω.

10. Dispositif suivant l'une des revendications 1 à 6, caractérisé par le fait que les éléments de contact sont formés par des canaux de décharge dans un gaz (G), équipés d'électrodes.

11. Dispositif suivant la revendication 10, caractérisé par le fait que les électrodes sont formées par des sections, que recoupent en superposition les canaux de décharge dans le gaz (G), des lignes formant bus (S1).
